# EUROPEAN PATENT APPLICATION

(11) **EP 3 951 025 A1**
(43) Date of publication of application: **09.02.2022**
(21) Application number: 20782703.1
(22) Date of filing: 25.03.2020
(51) Int. Cl.: C30B 29/38, C23C 16/01, C23C 16/34, C30B 25/02, C30B 25/20, H01L 21/205

(54) **GAN SUBSTRATE WAFER AND METHOD FOR MANUFACTURING GAN SUBSTRATE WAFER**

(30) Priority: 29.03.2019 JP 2019066016; 22.05.2019 JP 2019095873; 12.06.2019 JP 2019109206
(71) Applicant: Mitsubishi Chemical Corporation, Chiyoda-ku Tokyo 100-8251 (JP)
(72) Inventor: ISO, Kenji, Tokyo 100-8251 (JP)
(74) Representative: Hoffmann Eitle
(86) International application number: PCT/JP2020/013298
(87) International publication number: WO 2020/203541

(57) **Abstract**

The present invention is aimed at providing: a GaN substrate wafer having an improved productivity, which can be preferably used for the production of a nitride semiconductor device in which a device structure is arranged on a GaN substrate having a carrier concentration increased by doping; and a method of producing the same. Provided is a (0001)-oriented GaN wafer which includes a first region arranged on an N-polar side and a second region arranged on a Ga-polar side via a regrowth interface therebetween. In this GaN wafer, the second region has a minimum thickness of 20 µm to 300 µm, and contains a region having a higher donor impurity total concentration than the first region. In the second region, a region within a specific length from a main surface of the Ga-polar side of the GaN substrate wafer is defined as a main doped region, and the second region may be doped such that at least the main doped region has a donor impurity total concentration of 1 × 10¹⁸ atoms/cm³ or higher.

## Description

### TECHNICAL FIELD

The present invention mainly relates to a GaN substrate wafer and a method of producing the same. The term "GaN substrate wafer" used herein refers to a substrate wafer composed of GaN (gallium nitride). The term "substrate wafer" used herein refers to a wafer that is mainly used as a substrate in a production process of a semiconductor device.

### BACKGROUND ART

Substrates used in InGaN-based laser diodes (LD) that are commercially produced today are GaN substrates having a relatively high carrier concentration. Recently, vertical GaN power devices using such GaN substrates have been actively studied and developed.

When growing a thick GaN film on a sapphire wafer by HVPE (Hydride Vapor Phase Epitaxy), if a region with a high impurity concentration and a region with a low impurity concentration are arranged on top and bottom of the thick GaN film, respectively, a GaN substrate wafer having the region with a low impurity concentration on a back surface side and the region with a high impurity concentration on a front surface side can be obtained by peeling the thick GaN film from the sapphire wafer (Patent Documents 1 and 2).

### RELATED ART DOCUMENTS

### PATENT DOCUMENTS

Patent Document 1: Japanese Unexamined Patent Application Publication No. 2007-70154
Patent Document 2: Japanese Unexamined Patent Application Publication No. 2007-251178

### SUMMARY OF THE INVENTION

### PROBLEMS TO BE SOLVED BY THE INVENTION

In the production of a GaN substrate wafer having a region with a low impurity concentration on a back surface side and a region with a high impurity concentration on a front surface side by the method disclosed in Patent Document 1 or 2, it is necessary to grow a thick GaN film on a single sapphire wafer by HVPE for every single GaN substrate wafer to be produced. Therefore, the methods disclosed in Patent Document 1 or 2 cannot be deemed to have a high production efficiency.

### MEANS FOR SOLVING THE PROBLEMS

The present inventor discovered that a GaN substrate wafer having a region with an increased impurity concentration only on a front surface side can be produced more efficiently by preparing a GaN wafer having a low impurity concentration in advance and subsequently growing thereon a GaN layer having a high impurity concentration at a specific thickness.

The present invention was made based on such an idea, and embodiments of the present invention include the followings.

[1] A (0001)-oriented GaN substrate wafer, including a first region arranged on an N-polar side and a second region arranged on a Ga-polar side via a regrowth interface therebetween,
   wherein the second region has a minimum thickness of 20 µm to 300 µm, and contains a region having a higher donor impurity total concentration than the first region.
[2] The GaN substrate wafer according to [1], wherein at least a portion of the region having a higher donor impurity total concentration than the first region has a carrier concentration of 1 × 10¹⁸ cm⁻³ or higher.
[3] The GaN substrate wafer according to [1] or [2], satisfying any condition selected from the following (1) to (3) :
   (1) having a diameter of 50 mm to 55 mm and a thickness of 250 µm to 450 µm;
   (2) having a diameter of 100 mm to 105 mm and a thickness of 350 µm to 750 µm; and
   (3) having a diameter of 150 mm to 155 mm and a thickness of 450 µm to 800 µm.
[4] The GaN substrate wafer according to any one of [1] to [3], wherein the second region includes a main doped region having a donor impurity total concentration of 1 × 10¹⁸ atoms/cm³ or higher.
[5] The GaN substrate wafer according to [4], wherein, in the second region, a region within a specific length from a main surface of a GaN-polar side is the main doped region, and the specific length is 1 µm or longer.
[6] The GaN substrate wafer according to [5], wherein the minimum thickness of the second region is 1.2 times or less of the specific length.
[7] The GaN substrate wafer according to any one of [4] to [6], wherein, in the main doped region, a variation in the donor impurity total concentration along a c-axis direction is in a range of ±25% from a median value.
[8] The GaN substrate wafer according to any one of [1] to [7], wherein an impurity contained in the second region at the highest concentration is Si or Ge.
[9] The GaN substrate wafer according to any one of [4] to [7], wherein an impurity contained in the main doped region at the highest concentration is Si or Ge.
[10] The GaN substrate wafer according to any one of [4] to [9], wherein a total concentration of donor impurities excluding Si in the main doped region is 10% or less of the Si concentration.
[11] The GaN substrate wafer according to any one of [4] to [10], wherein the main doped region has a Ge concentration of 1 × 10¹⁸ atoms/cm³ or higher and an Si concentration of 4 × 10¹⁷ atoms/cm³ or higher.
[12] The GaN substrate wafer according to any one of [1] to [11], wherein impurity concentrations of at least one of the first region and the second region satisfy one or more conditions selected from the following (a) to (c):
   (a) the Si concentration is 5 × 10¹⁶ atoms/cm³ or higher;
   (b) the O concentration is 3 × 10¹⁶ atoms/cm³ or lower; and
   (c) the H concentration is 1 × 10¹⁷ atoms/cm³ or lower.
[13] The GaN substrate wafer according to any one of [1] to [12], wherein the first region has an Si concentration of lower than 1 × 10¹⁸ atoms/cm³.
[14] The GaN substrate wafer according to any one of [1] to [13], wherein the regrowth interface is a rough surface.
[15] The GaN substrate wafer according to any one of [1] to [14], wherein a dislocation density on the main surface of the Ga-polar side is 0.5 times to less than 2 times of that of the first region in the vicinity of the regrowth interface.
[16] The GaN substrate wafer according to any one of [1] to [15], wherein the main surface of the Ga-polar side is a flat surface.
[17] An epitaxial wafer, including:
   the GaN substrate wafer according to any one of [1] to [16]; and
   a nitride semiconductor layer epitaxially grown on a Ga-polar surface of the GaN substrate wafer.
[18] A method of producing an epitaxial wafer, the method including the steps of:
   preparing the GaN substrate wafer according to any one of [1] to [16]; and
   growing a nitride semiconductor layer on a Ga-polar surface of the GaN substrate wafer to obtain an epitaxial wafer.
[19] A method of producing a semiconductor device, the method including the steps of:
   preparing the GaN substrate wafer according to any one of [1] to [16];
   growing a nitride semiconductor layer on a Ga-polar surface of the GaN substrate wafer to obtain an epitaxial wafer; and
   removing at least a portion of the first region of the GaN substrate wafer.
[20] A method of producing a GaN substrate wafer, the method including:
   a second step of obtaining a second c-plane GaN wafer by growing a (0001)-oriented second thick GaN film on a substrate by HVPE and subsequently slicing the second thick GaN film; and
   a third step of growing a (0001)-oriented GaN film of 500 µm or less in thickness on the second c-plane GaN wafer by HVPE, which GaN film includes a region having a higher donor impurity total concentration than the second c-plane GaN wafer.
[21] A method of producing a GaN substrate wafer that includes a first region arranged on an N-polar side and a second region arranged on a Ga-polar side via a regrowth interface therebetween, the method including:
   (i) a first step of growing a (0001)-oriented first thick GaN film, which is composed of GaN not intentionally doped, on a seed wafer by HVPE, and subsequently obtaining at least one first c-plane GaN wafer from the first thick GaN film;
   (ii) a second step of obtaining a second c-plane GaN wafer by growing a (0001)-oriented second thick GaN film, which is composed of GaN not intentionally doped, on the first c-plane GaN wafer by HVPE and subsequently slicing the second thick GaN film; and
   (iii) a third step of growing a (0001)-oriented GaN film of 500 µm or less in thickness on the second c-plane GaN wafer by HVPE, which GaN film includes a region having a higher donor impurity total concentration than the second c-plane GaN wafer.
[22] The method of producing a GaN substrate wafer according to [20] or [21], wherein at least a portion of the region having a higher donor impurity total concentration than the second c-plane GaN wafer has a carrier concentration of 1 × 10¹⁸ cm⁻³ or higher.
[23] The method of producing a GaN substrate wafer according to any one of [20] to [22], wherein the GaN substrate wafer satisfies any condition selected from the following (1) to (3):
   (1) having a diameter of 50 mm to 55 mm and a thickness of 250 µm to 450 µm;
   (2) having a diameter of 100 mm to 105 mm and a thickness of 350 µm to 750 µm; and
   (3) having a diameter of 150 mm to 155 mm and a thickness of 450 µm to 800 µm.
[24] The method of producing a GaN substrate wafer according to any one of [20] to [23], wherein the GaN film includes a specific doped region which has a length of 1 µm or longer in a c-axis direction from an upper surface of the GaN film, and in which the donor impurity total concentration is 1 × 10¹⁸ atoms/cm³ or higher.
[25] The method of producing a GaN substrate wafer according to [24], wherein the length of the specific doped region in the c-axis direction is 20 µm or longer.
[26] The method of producing a GaN substrate wafer according to [24] or [25], wherein, in the specific doped region, a variation in the donor impurity total concentration along the c-axis direction is within a median value ± 25%.
[27] The method of producing a GaN substrate wafer according to any one of [24] to [26], wherein the GaN film includes an intervening region of 50 µm or less in thickness between the specific doped region and the second c-plane GaN wafer.
[28] The method of producing a GaN substrate wafer according to any one of [24] to [27], wherein an impurity contained in the specific doped region at the highest concentration is Si or Ge.
[29] The method of producing a GaN substrate wafer according to any one of [24] to [28], wherein a total concentration of donors excluding Si in the specific doped region is 10% or less of the Si concentration.
[30] The method of producing a GaN substrate wafer according to any one of [24] to [29], wherein the specific doped region has a Ge concentration of 1 × 10¹⁸ atoms/cm³ or higher and an Si concentration of 4 × 10¹⁷ atoms/cm³ or higher.
[31] The method of producing a GaN substrate wafer according to any one of [20] to [30], including the thinning step of thinning the GaN film after the third step.
[32] The method of producing a GaN substrate wafer according to [31], wherein the GaN film has a thickness difference of 200 µm or less before and after the thinning step.
[33] The method of producing a GaN substrate wafer according to any one of [20] to [32], wherein the GaN substrate wafer and the second c-plane GaN wafer have different off-cut orientations.
[34] The method of producing a GaN substrate wafer according to any one of [20] to [33], further including, between the second step and the third step:
   the planarization step of planarizing a Ga-polar surface of the second c-plane GaN wafer obtained in the second step; and
   the roughening step of roughening the Ga-polar surface by etching.
[35] The method of producing a GaN substrate wafer according to any one of [31] to [34], wherein the thinning of the GaN film in the thinning step is performed without slicing.

### EFFECTS OF THE INVENTION

According to the present invention, a high-performance GaN substrate wafer having a high carrier concentration can be provided. In addition, according to the present invention, a method of efficiently producing a GaN substrate wafer having a high carrier concentration can be provided. Accordingly, the present invention can be applied to the production of a nitride semiconductor device in which a device structure is arranged on a GaN substrate having a high carrier concentration.

### BRIEF DESCRIPTION OF THE DRAWINGS

[FIG. 1] FIG. 1 is a perspective view illustrating a GaN substrate wafer according to one embodiment.
[FIG. 2] FIG. 2 is a cross-sectional view illustrating the GaN substrate wafer according to one embodiment.
[FIG. 3] FIG. 3 is a cross-sectional view illustrating a GaN substrate wafer according to another embodiment.
[FIG. 4] FIG. 4 is a process cross-sectional view for describing the steps of producing a nitride semiconductor device using a GaN substrate wafer according to one embodiment.
[FIG. 5] FIG. 5 is a process cross-sectional view for describing a method of producing a GaN substrate wafer according to one embodiment
[FIG. 6] FIG. 6 is a process cross-sectional view for describing a method of producing a GaN substrate wafer according to another embodiment.
[FIG. 7] FIG. 7 is a process cross-sectional view for describing a method of producing a GaN substrate wafer according to yet another embodiment.
[FIG. 8] FIG. 8 is a schematic drawing that illustrates a basic configuration of an HVPE apparatus.
[FIG. 9] FIG. 9 is a graph showing the carrier concentration of the GaN substrate wafer produced in Example.

### MODE FOR CARRYING OUT THE INVENTION

Embodiments of the present invention will now be described in detail. The following descriptions of requirements are merely examples (representative examples) of the embodiments of the present invention, and the present invention is not limited to the contents thereof as long as they do not depart from the gist of the present invention.

Unless otherwise specified, the expression "X to Y" (wherein, X and Y are arbitrary numbers) used herein encompasses not only the meaning of "X or more but Y or less", but also the meaning of "preferably larger than X" and "preferably smaller than Y".

### 1. GaN Substrate Wafer

One embodiment of the present invention relates to a GaN substrate wafer.

The GaN substrate wafer according to one embodiment is a (0001)-oriented GaN substrate wafer which is composed of a first region arranged on an N-polar side and a second region arranged on a Ga-polar side via a regrowth interface therebetween. The second region has a minimum thickness of 20 µm to 300 µm. The second region contains a region having a higher donor impurity total concentration than the first region. It is noted here that the term "impurity" used herein means a component other than Ga element and N element that are contained in a GaN substrate.

At least a portion of the region can have a carrier concentration of 1 × 10¹⁸ cm⁻³ or higher, 2 × 10¹⁸ cm⁻³ or higher, 3 × 10¹⁸ cm⁻³ or higher, 4 × 10¹⁸ cm⁻³ or higher, 6 × 10¹⁸ cm⁻³ or higher, or 8 × 10¹⁸ cm⁻³ or higher. It is noted here that, unless otherwise specified, the term "carrier concentration" used herein means a carrier concentration at room temperature.

The term "(0001)-oriented GaN wafer" used herein refers to a GaN wafer having main surfaces (large-area surfaces) parallel to or substantially parallel to the (0001) crystal plane, namely the c-plane, and is also called "c-plane GaN wafer".

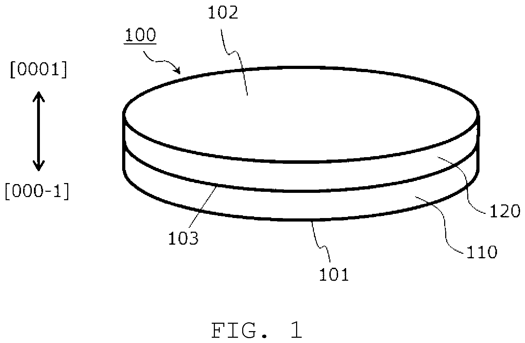

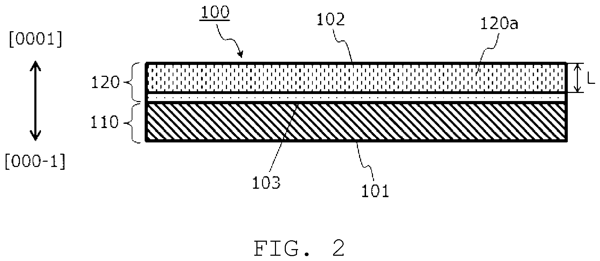

FIGs. 1 and 2 illustrate an example of a GaN substrate wafer according to one embodiment. FIG. 1 is a perspective view, and FIG. 2 is a cross-sectional view.

A GaN substrate wafer 100 illustrated in FIGs. 1 and 2 is a self-supporting substrate wafer consisting of only GaN crystal, and one of its two main surfaces is an N-polar surface 101, while the other is a Ga-polar surface 102.

The N-polar surface 101 and the Ga-polar surface 102 are parallel to each other.

The GaN substrate wafer 100 is (0001)-oriented, and an inclination of the Ga-polar surface 102 from the (0001) crystal plane is 10° or smaller (including 0°). The inclination may be 0.2° or larger. Further, the inclination is preferably 5° or smaller, more preferably 2.5° or smaller. The inclination may be 1.5° or smaller, or 1° or smaller.

The diameter of the GaN substrate wafer 100 is usually 45 mm or larger, and may be 95 mm or larger, or 145 mm or larger. The diameter is typically, for example, 50 to 55 mm (about 2 inches), 100 to 105 mm (about 4 inches), or 150 to 155 mm (about 6 inches).

A preferred range of the thickness of the GaN substrate wafer 100 varies depending on the diameter.

When the diameter of the GaN substrate wafer 100 is about 2 inches, the thickness is preferably 250 µm or greater, more preferably 300 µm or greater, still more preferably 350 µm or greater, but preferably 450 µm or less, more preferably 400 µm or less.

When the diameter of the GaN substrate wafer 100 is about 4 inches, the thickness is preferably 350 µm or greater, more preferably 400 µm or greater, but preferably 750 µm or less, more preferably 650 µm or less, still more preferably 600 µm or less.

When the diameter of the GaN substrate wafer 100 is about 6 inches, the thickness is preferably 450 µm or greater, more preferably 550 µm or greater, but preferably 800 µm, more preferably 700 µm or less.

As described above, the GaN substrate wafer 100 usually has a disk shape; however, in a modification example, the main surfaces may have a square shape, a rectangular shape, a hexagonal shape, an octagonal shape, an elliptical shape or the like, or may have an amorphous shape. In such a modification example, the above-described "diameter" is interchangeable with "a length of shortest straight line passing through the center of gravity of a main surface".

The N-polar surface 101 of the GaN substrate wafer 100 is a "back surface", and may be a mirror-finished surface, a rough surface, or a mat-finished surface.

The Ga-polar surface 102 of the GaN substrate wafer 100 is a "front surface" and, when the GaN substrate wafer 100 is used in the production of a nitride semiconductor device, a nitride semiconductor layer is usually epitaxially grown on the Ga-polar surface 102.

The Ga-polar surface 102 may be a surface of a grown crystal as is (as-grown); however, it is preferably a surface (flat surface) that has been planarized by a process such as grinding, CMP (Chemical Mechanical Polishing), or etching. The root-mean-square (RMS) roughness of the Ga-polar surface 102, which is measured under an atomic force microscope (AFM), is preferably less than 5 nm, more preferably less than 2 nm, still more preferably less than 1 nm, and may be less than 0.5 nm, in a measurement area of 2 µm × 2 µm. The Ga-polar surface 102 may be a surface formed by cutting; however, it is preferably a surface that has been subjected to only planarization by grinding, CMP, etching or the like without cutting.

The GaN substrate wafer 100 has a regrowth interface 103 between the two main surfaces, and has a first region 110 on the N-polar side and a second region 120 on the Ga-polar side via the regrowth interface 103 therebetween. The term "regrowth interface" used herein means an interface that is generated when a GaN crystal is grown on an arbitrary substrate, and the presence thereof can be confirmed by, for example, cathodoluminescence imaging of a cross-section of the GaN substrate wafer under a scanning electron microscope, or observation of the cross-section under a fluorescent microscope.

The regrowth interface 103 is preferably, but not necessarily, parallel to the Ga-polar surface 102. When the regrowth interface 103 is inclined from the Ga-polar surface 102, the second region 120 usually has a minimum thickness at one end of the inclined direction and a maximum thickness at the other end. A difference in the thickness of the second region 120 between the one end and the other end is preferably not larger than 200 µm.

In a production process of a nitride semiconductor device using the GaN substrate wafer 100, it is expected that the first region 110 be removed eventually. In other words, a nitride semiconductor device chip produced using the GaN substrate wafer 100 is expected not to contain any part originating from the first region 110. In this mode of use, there is no particularly requirement in terms of the electrical characteristics of the GaN crystal constituting the first region 110.

The GaN crystal constituting the first region 110 is usually grown by HVPE and, therefore, satisfies one or more conditions selected from the following (a) to (c) regarding the impurity concentrations. The term "HVPE" used herein means hydride vapor phase epitaxy.
(a) the Si concentration is 5 × 10¹⁶ atoms/cm³ or higher;
(b) the O concentration is 3 × 10¹⁶ atoms/cm³ or lower; and
(c) the H concentration is 1 × 10¹⁷ atoms/cm³ or lower. Since the GaN crystal constituting the first region 110 is not intentionally doped, the Si concentration thereof is preferably lower than 1 × 10¹⁸ atoms/cm³.

In GaN that is grown by HVPE and not intentionally doped, the Si concentration can be 5 × 10¹⁷ atoms/cm³ or lower, the O concentration can be 2 × 10¹⁷ atoms/cm³ or lower, the H concentration can be 5 × 10¹⁶ atoms/cm³ or lower, and the concentration of each impurity other than Si, O and H can be 5 × 10¹⁵ atoms/cm³ or lower. It is noted here that the term "intentionally doped" used herein means that an element of interest is added as a raw material in a process of growing a GaN crystal.

The second region 120 is usually grown on the first region 110 by HVPE. The reason why the regrowth interface 103 exists between the first region 110 and the second region 120 is because the step of growing the first region 110 and the step of growing the second region 120 are not continuous.

The minimum thickness of the second region 120 is at least 20 µm, preferably 40 µm or greater, more preferably 50 µm or greater, and may be 100 µm or greater. The reason for this is to allow, in a production process of a nitride semiconductor device chip using the GaN substrate wafer 100, the second region 120 remaining after the removal of the first region 110 from the substrate wafer 100 to play a role as a substrate that supports the structure of the semiconductor device chip. The term "minimum thickness" used herein means a thickness at a spot where the thickness is the smallest.

An upper limit of the minimum thickness of the second region 120 is 300 µm.

When the Ga-polar surface 102 and the regrowth interface 103 are parallel to each other and the second region 120 has a uniform thickness, the second region 120 is deemed to have a minimum thickness at all spots.

In the second region 120, a region within a specific length L from the Ga-polar surface 102 of the GaN substrate wafer 100 is defined as a main doped region 120a. The second region 120 is doped such that at least the main doped region 120a has a donor impurity total concentration of 1 × 10¹⁸ atoms/cm³ or higher. The term "donor impurity total concentration" used herein refers to a sum of the concentrations of all types of donor impurities.

The specific length L is usually at least 1 µm, and may be, for example, 5 µm or longer, 10 µm or longer, 20 µm or longer, 25 µm or longer, 50 µm or longer, 75 µm or longer, 100 µm or longer, 150 µm or longer, or 200 µm or longer.

In at least a portion of the main doped region 120a, the donor impurity total concentration is preferably 2 × 10¹⁸ atoms/cm³ or higher, more preferably 3 × 10¹⁸ atoms/cm³ or higher, and may be, for example, 4 × 10¹⁸ atoms/cm³ or higher, 6 × 10¹⁸ atoms/cm³ or higher, or 8 × 10¹⁸ atoms/cm³ or higher.

At least a portion, preferably the entirety, of the main doped region 120a has a higher carrier concentration than the first region 110.

In a preferred embodiment, the specific length L is set such that, even when the second region 120 is partially removed from the GaN substrate wafer 100 in addition to the first region 110 and the main doped region 120a is thereby exposed in a production process of a semiconductor device chip using the GaN substrate wafer 100, a GaN substrate consisting of only the main doped region 120a can support the structure of the resulting semiconductor device chip. In this embodiment, the specific length L is at least 20 µm, preferably 40 µm or longer, more preferably 50 µm or longer, and may be 100 µm or longer.

In this preferred embodiment, a minimum thickness t120 of the second region 120 is preferably 1.2 times or less of the specific length L.

In this preferred embodiment, it is desired that a variation in the carrier concentration along the c-axis direction be small in the main doped region 120a. Accordingly, a variation in the donor impurity total concentration along the c-axis direction in the main doped region 120a is preferably within ±25%, more preferably within ±20%, still more preferably within ±15%, yet still more preferably within ±10%, from a median value.

The donor impurity total concentration in the second region 120, including the main doped region 120a, can be controlled to be 5 × 10¹⁹ atoms/cm³ or lower, or 2 × 10¹⁹ atoms/cm³ or lower, so as to prevent marked deterioration of the crystal quality caused by excessive doping.

The reason why a dopant added to the second region 120 for increasing the carrier concentration is a donor impurity is because, in GaN, a donor generally exhibits a higher activation rate than an acceptor. The term "activation rate" used herein refers to a ratio of the carrier concentration with respect to the concentration of a dopant in doped GaN.

Examples of a donor impurity that may be contained in the second region 120 include Group 14 elements such as Si (silicon) and Ge (germanium), and Group 16 elements such as O (oxygen) and S (sulfur).

A donor impurity contained in the second region 120 or the main doped region 120a at the highest concentration is preferably Si or Ge, and this is because of the following two main reasons.

First, Si and Ge, along with O, are donor impurities having a high activation rate.

Secondly, while facet growth is required for obtaining GaN doped with O at a high concentration, GaN doped with Si or Ge at a high concentration can be obtained by c-plane growth.

Facet growth is a technique for growing a (0001)-oriented GaN film such that its growth surface is covered with pits. In contrast, c-plane growth is a process of growing such a GaN film in a manner that its growth surface is flat.

Threading dislocations have a property of being concentrated on the bottom of pits; therefore, when the second region 120 is formed by facet growth, the uniformity of the threading dislocation density on the Ga-polar surface 102 is deteriorated. However, the manufacturers of nitride semiconductor devices prefer GaN substrate wafers having a highly uniform threading dislocation density.

It is disadvantageous to form the second region 120 by facet growth also from the standpoint of the productivity of the substrate wafer 100. This is because, as compared to a GaN film obtained by c-plane growth, a GaN film obtained by facet growth requires a longer processing time for surface planarization.

In one example, by controlling the total concentration of donor impurities excluding Si in the main doped region 120a to be 10% or less, 5% or less, or 1% or less of the Si concentration, the carrier concentration in the same region can be controlled through adjustment of the Si concentration.

In a preferred mode, when the main doped region 120a is doped with Ge and the concentration thereof is 1 × 10¹⁸ atoms/cm³ or higher, the Si concentration in the same region is preferably 4 × 10¹⁷ atoms/cm³ or higher.

The second region 120 is usually grown by HVPE and, therefore, satisfies one or more conditions selected from the following (a') to (c') regarding the impurity concentrations:
(a') the Si concentration is 5 × 10¹⁶ atoms/cm³ or higher;
(b') the O concentration is 3 × 10¹⁶ atoms/cm³ or lower; and
(c') the H concentration is 1 × 10¹⁷ atoms/cm³ or lower.

It is noted here that the conditions of the second region 120 may be independent of the above-described conditions of the first region 110, i.e. the conditions of the second region 120 may be the same as, or different from the conditions of the first region 110.

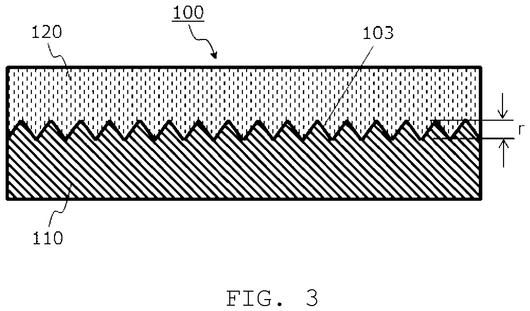

In one example, as illustrated in FIG. 3, the regrowth interface 103 between the first region 110 and the second region 120 may be a rough surface. For example, when the surface of the first region 110 is roughened by etching before growing the second region 120, the regrowth interface 103 can be a rough surface. When a direction that is perpendicular to the regrowth interface 103 and extends from the first region 110 toward the second region 120 is defined as height direction and a difference in height between the highest point and the lowest point on the regrowth interface is defined as roughness (r) of the regrowth interface, the roughness (r) can be, for example, 0.3 µm to 12 µm.

The dislocation density on the Ga-polar surface 102 of the GaN substrate wafer 100 can be 0.5 times to less than 2 times, 2 times to less than 5 times, or 5 times to less than 10 times of the dislocation density of the first region 110 in the vicinity of the regrowth interface 103. As a method of controlling the dislocation density on the Ga-polar surface 102 to be in the above-described range, for example, a method of roughening the regrowth interface 103 may be employed. The "vicinity of the regrowth interface 103" means a region of up to 1 µm from the regrowth interface 103 to the side of the Ga-polar surface 102. When the regrowth interface 103 is a rough surface, the highest point of the regrowth interface is used as a reference.

In addition, the edges of the GaN substrate wafer 100 may be chamfered, although this is not illustrated in FIGs. 1 to 3. Further, as required, the substrate wafer 100 may be provided with various markings such as an orientation flat or notch that indicates the crystal orientation, and an index flat for making it easier to identify the front surface and the back surface.

A semiconductor device produced using the GaN substrate wafer 100 is basically a nitride semiconductor device. The term "nitride semiconductor device" used herein refers to a semiconductor device in which a major part of the device structure is constituted by a nitride semiconductor.

A nitride semiconductor is also called "nitride-based Group III-V compound semiconductor", "Group III nitride-based compound semiconductor", "GaN-based semiconductor" or the like, and contains GaN along with a compound in which gallium of GaN is partially or entirely substituted with other Periodic Table Group 13 element (e.g., B, Al, or In).

The type of a nitride semiconductor device that can be produced using the GaN substrate wafer 100 is not restricted, and examples thereof include: light-emitting devices, such as laser diodes (LDs) and light-emitting diodes (LEDs); and electronic devices, such as rectifiers, bipolar transistors, field-effect transistors, and high electron mobility transistors (HEMTs).

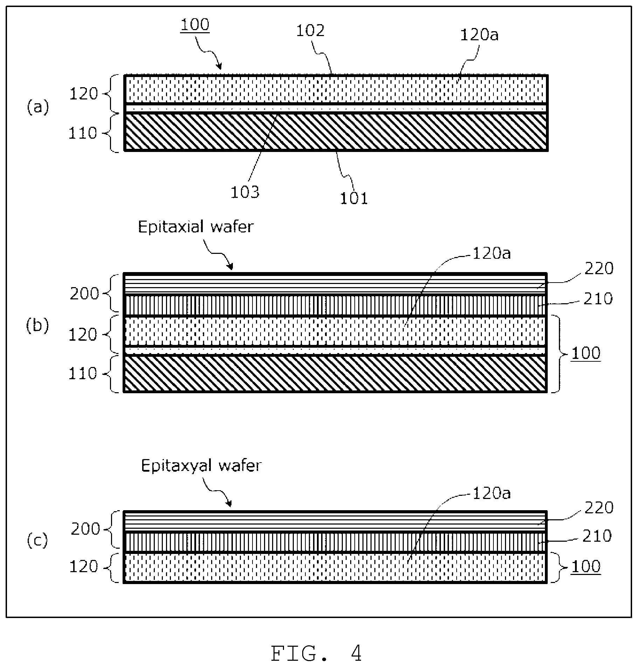

In the production of a nitride semiconductor device using the GaN substrate wafer 100, the GaN substrate wafer 100 is prepared as illustrated in FIG. 4(a) and, for example, an epitaxial film 300 which includes at least an n-type nitride semiconductor layer 310 and a p-type nitride semiconductor layer 320 is subsequently grown on the Ga-polar surface 102 by metalorganic vapor phase epitaxy (MOVPE) as illustrated in FIG. 4(b), whereby an epitaxial wafer is formed.

After the thus obtained epitaxial wafer is subjected to a semiconductor processing that may include etching, ion implantation, electrode formation, protective film formation and the like, the epitaxial wafer is divided into nitride semiconductor device chips. Prior to this division, for thinning of the epitaxial wafer, the first region 110 of the GaN substrate wafer 100 is usually removed by grinding, etching or the like as illustrated in FIG. 4(c).

This thinning process may be performed such that a ring-form thick part remains on the outer periphery of the epitaxial wafer. In other words, the first region 110 of the GaN substrate wafer 100 may be removed only in those parts excluding the outer periphery of the epitaxial wafer.

In FIG. 4(c), the second region 120 is also partially removed from the GaN substrate wafer 100 such that the main doped region 120a is exposed on the N-polar surface side of the thus thinned epitaxial wafer, leaving only the main doped region 120a. After the formation of an electrode on the surface of the exposed main doped region 120a, the epitaxial wafer 300 may be divided as well.

### 2. Method of Producing GaN Substrate Wafer

Next, a method of producing a GaN substrate wafer, which is another embodiment of the present invention, will be described. The below-described production method is a preferred mode of producing the above-described GaN substrate wafer according to one embodiment of the present invention. Examples of a preferred mode of the GaN substrate wafer obtained by the below-described method of producing a GaN substrate wafer include the above-described GaN substrate wafer.

The above-described GaN substrate wafer 100 according to one embodiment can be preferably produced by the below-described method. This method is applied to the production of a GaN substrate wafer having an N-polar side and a Ga-polar side via a regrowth interface therebetween, and includes the following steps:
(ii') the second step of obtaining a second c-plane GaN wafer by growing a (0001)-oriented second thick GaN film on a substrate by HVPE and subsequently slicing the second thick GaN film; and
(iii') the third step of growing a (0001)-oriented GaN film of 500 µm or less in thickness on the second c-plane GaN wafer by HVPE, on which GaN film a region having a higher donor impurity total concentration than the second c-plane GaN wafer is arranged.

The method preferably further includes the following first step added as the step of producing the substrate used in the second step. Accordingly, the following first step is optional.
(i) the first step of obtaining at least one first c-plane GaN wafer by growing a (0001)-oriented first thick GaN film, which is composed of GaN not intentionally doped, on a seed wafer by HVPE and processing the first thick GaN film;
(ii) the second step of growing a (0001)-oriented second thick GaN film, which is composed of GaN not intentionally doped, by HVPE on the first c-plane GaN wafer obtained in the first step, and slicing a second c-plane GaN wafer from the second thick GaN film; and
(iii) the third step of obtaining a laminated structure by growing a (0001)-oriented GaN film of 500 µm or less in thickness by HVPE on the second c-plane GaN wafer obtained in the second step.

It is noted here that at least a portion of the GaN film is doped such that it has a higher donor impurity total concentration than the second c-plane GaN wafer.

In the present specification, "on a wafer" is synonymous to "on the surface of a wafer".

The above-described first to third steps will now be described in more detail.

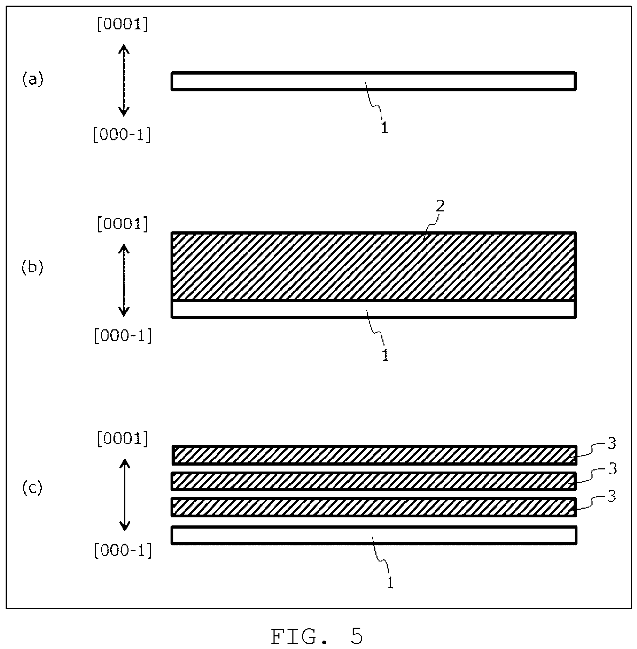

In the first step, a seed wafer 1 illustrated in FIG. 5(a) is prepared, and a (0001)-oriented first thick GaN film 2, which is composed of GaN not intentionally doped, is subsequently grown thereon by HVPE as illustrated in FIG. 5(b). Further, at least one first c-plane GaN wafer 3 is obtained by processing the first thick GaN film 2 as illustrated in FIG. 5(c).

One example of the seed wafer 1 is a c-plane sapphire wafer and, preferably, a peeling layer may be arranged on its main surface. A c-plane sapphire wafer having a peeling layer can be formed by, for example, growing a GaN layer of several hundred nanometers in thickness on a c-plane sapphire wafer by MOVPE via a low-temperature buffer layer, further forming a Ti (titanium) layer of several tens nanometers in thickness on the GaN layer by vacuum deposition, and subsequently annealing the resultant in a mixed gas of 80% H₂ (hydrogen gas) and 20% NH₃ (ammonia), for example, at 1,060°C for 30 minutes.

The seed wafer 1 may also be a c-plane GaN wafer produced by a separate step.

The first thick GaN film 2 is grown to such a thickness that at least one self-supporting c-plane GaN wafer can be produced by processing the first thick GaN film 2. In a preferred example, the first thick GaN film 2 is grown to a thickness of several millimeters or greater, and at least two first c-plane GaN wafers 3 are sliced therefrom.

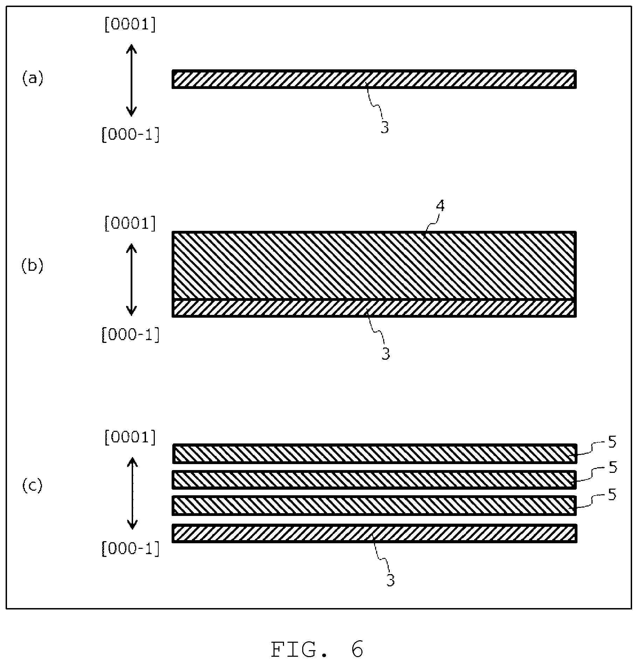

FIG. 6(a) is a cross-sectional view that illustrates a single first c-plane GaN wafer 3 produced in the first step. It is noted here, however, that the first c-plane GaN wafer 3 is not restricted to be one obtained by the first step.

In the second step, a (0001)-oriented second thick GaN film 4, which is composed of GaN not intentionally doped, is grown on the Ga-polar surface of the first c-plane GaN wafer 3 by HVPE as illustrated in FIG. 6(b), and second c-plane GaN wafers 5 are subsequently sliced from the second thick GaN film 4 as illustrated in FIG. 6(c). The second thick GaN film 4 is grown to such a thickness that at least one second c-plane GaN wafer 5 can be produced by processing the second thick GaN film 4. In a preferred example, the second thick GaN film 4 is grown to a thickness of several millimeters or greater, and at least two second c-plane GaN wafers 5 are sliced therefrom.

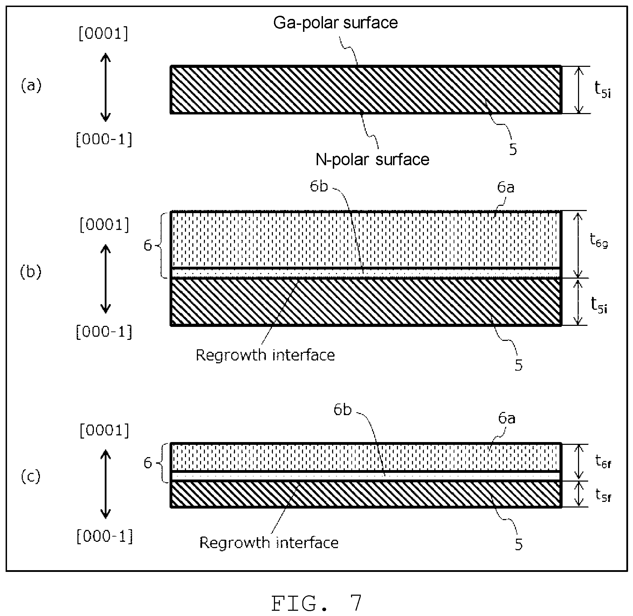

As illustrated in the cross-sectional view of FIG. 7(a), the second c-plane GaN wafer 5 has an N-polar surface and a Ga-polar surface, which are parallel to each other, as main surfaces.

In the production of the above-described GaN substrate wafer 100 according to one embodiment, at the time of slicing the second c-plane GaN wafer 5 from the second thick GaN film 4 in the second step, it is preferred, but not necessarily, that the inclination angle (off-cut angle) and the inclination direction (off-cut direction) of the Ga-polar surface from the (0001) crystal plane in the second GaN wafer 5 be the same as the off-cut angle and the off-cut direction that the GaN substrate wafer 100 should have.

The off-cut orientation that the GaN substrate wafer 100 should have varies depending on the demand from a semiconductor device manufacturer using the GaN substrate wafer 100; however, preparation of the second c-plane GaN wafer 5 with various off-cut orientations accordingly can lead to a reduction in the production efficiency of the GaN substrate wafer 100. Attention must also be given to the point that the optimum conditions for the growth of a GaN film 6 on the second c-plane GaN wafer 5 by HVPE in the subsequent third step are variable depending on the off-cut orientation of the second c-plane GaN wafer 5.

An initial thickness t5i of the second c-plane GaN wafer 5 may be less than the thickness that a GaN substrate wafer used in the production of a nitride semiconductor device usually has. This is because the second c-plane GaN wafer 5 only needs to not be broken before the subsequent third step, which is different from a GaN substrate wafer that is required to withstand a semiconductor processing constituted by a large number of steps.

For example, when the second c-plane GaN wafer 5 has a diameter of about 2 inches, the initial thickness t5i thereof is preferably 300 µm or less, and may be 250 µm or less, or 200 µm or less.

By reducing the initial thickness t5i of the second c-plane GaN wafer 5, the number of second c-plane GaN wafers 5 that can be sliced from the second thick GaN film 4 can be increased.

In the third step, as illustrated in FIG. 7(b), a (0001)-oriented GaN film 6 of 500 µm or less in thickness is grown on the Ga-polar surface of the second c-plane GaN wafer 5 by HVPE to obtain a laminated structure. In this process, a regrowth interface is formed between the second c-plane GaN wafer 5 and the GaN film 6.

Usually, the Ga-polar surface of the second c-plane GaN wafer 5 is processed to be flat by appropriately using a technique such as grinding, polishing, or CMP before growing the GaN film 6 thereon (planarization step).

In one example, the GaN film 6 may be grown after planarizing the Ga-polar surface of the second c-plane GaN wafer 5 and subsequently further processing the Ga-polar surface to be a rough surface by etching (roughening step). When the second c-plane GaN wafer 5 has a dislocation density in a lower half of 10⁶ cm⁻² or less, even if the Ga-polar surface thereof is roughened, the dislocation density of the GaN film 6 grown thereon is not markedly reduced. Rather, the dislocation density of the GaN film 6 will be equal to or higher than that of the second c-plane GaN wafer 5, specifically 0.5 times to less than 2 times, or even more, of the dislocation density on the Ga-polar surface of the second c-plane GaN wafer 5.

An advantage of roughening the Ga-polar surface of the second c-plane GaN wafer 5 is that it makes the laminated structure formed by the growth of the GaN film 6 less likely to be cracked, and the incidence of cracking can be less than one-tenth of that in a case where the Ga-polar surface is not roughened.

The use of HCl (hydrogen chloride) as an etching gas enables to roughen the Ga-polar surface of GaN without using an etching mask. By providing an HCl supply line for etching on an HVPE apparatus used for growing the GaN film 6, the Ga-polar surface of the second c-plane GaN wafer 5 can be roughened inside a reactor of the HVPE apparatus immediately before growing the GaN film 6.

Preferred etching conditions in the case of using HCl as an etching gas are as follows.

The HCl partial pressure is, for example, 0.002 to 0.05 atm.

The H₂ partial pressure is, for example, 0.2 to 0.8 atm.

The NH₃ partial pressure is, for example, 0.01 to 0.05 atm. By providing a NH₃ flow, the Ga-polar surface of GaN is roughened more uniformly.

The etching temperature is, for example, 900 to 1,050°C.

The etching time is, for example, 1 to 60 minutes.

When the roughness of the Ga-polar surface of the second c-plane GaN wafer after the etching is defined as a difference in height between the highest point and the lowest point, the roughness can be, for example, 0.3 µm to 12 µm.

In the etching with HCl, when the conditions other than the etching time are fixed, not only the etching time but also the roughness of the Ga-polar surface of the second c-plane GaN wafer tend to be increased.

Oddly, when the Ga-polar surface is etched with HCl to a roughness of 0.6 to 12 µm, the dislocation density of the GaN film 6 grown thereon increases to several times to up to about 10 times of the dislocation density of the second c-plane GaN wafer 5. Accordingly, taking into consideration the production efficiency as well, the etching time in the case of using HCl as an etching gas is preferably set such that the roughness of the Ga-polar surface does not exceed 0.5 µm.

For example, the etching time is preferably 5 minutes or shorter when the Ga-polar surface of the second c-plane GaN wafer 5 is etched under the conditions where the HCl partial pressure is 0.01 to 0.02 atm, the H₂ partial pressure is 0.05 to 0.08 atm, the NH₃ partial pressure is 0.01 to 0.03 atm, and the temperature is 970 to 1,000°C.

In one example, a rough surface may be obtained by dry-etching the Ga-polar surface of the second c-plane GaN wafer 5 after forming thereon an etching mask patterned by a photolithography method. A dot pattern and a net pattern are typical examples of a preferred pattern of the etching mask. The dry-etching may be RIE (reactive ion etching) using Cl₂ (chlorine gas) or a chlorine-containing compound as an etching gas.

On the GaN film 6, a part doped to have a higher donor impurity total concentration than the second c-plane GaN wafer 5 is arranged. In at least a portion of this part, the carrier concentration may be 1 × 10¹⁸ cm⁻³ or higher, 2 × 10¹⁸ cm⁻³ or higher, 3 × 10¹⁸ cm⁻³ or higher, 4 × 10¹⁸ cm⁻³ or higher, 6 × 10¹⁸ cm⁻³ or higher, or 8 × 10¹⁸ cm⁻³ or higher. Si and Ge are preferably used as donor impurities.

In a preferred example, a specific doped region 6a may be arranged on the GaN film 6. An upper end ([0001]-side end) of the specific doped region 6a constitutes the upper surface of the GaN film 6, and it is preferred that the length of this region in the c-axis direction be 1 µm or longer and the donor impurity total concentration in the region be 1 × 10¹⁸ atoms/cm³ or higher. In other words, this length of the region means the thickness (height in the thickness direction) of a region having a donor impurity total concentration of 1 × 10¹⁸ atoms/cm³ or higher.

The length of the specific doped region 6a in the c-axis direction may be, for example, 5 µm or longer, 10 µm or longer, 20 µm or longer, 25 µm or longer, 50 µm or longer, 75 µm or longer, 100 µm or longer, 150 µm or longer, 200 µm or longer.

The donor impurity total concentration in the specific doped region 6a is preferably 2 × 10¹⁸ atoms/cm³ or higher, more preferably 3 × 10¹⁸ atoms/cm³ or higher, and may be, for example, 4 × 10¹⁸ atoms/cm³ or higher, 6 × 10¹⁸ atoms/cm³ or higher, or 8 × 10¹⁸ atoms/cm³ or higher.

At least a portion, preferably the entirety, of the specific doped region 6a has a carrier concentration higher than that of the second c-plane GaN wafer 5.

In a preferred embodiment, the length in the c-axis direction of the specific doped region 6a arranged on the GaN film 6 may be, for example, 20 µm or longer, 50 µm or longer, 100 µm or longer, such that a region having a sufficient carrier concentration can be arranged at a thickness of, for example, 20 µm or greater, 50 µm or greater, or 100 µm or greater, on the Ga-polar side of the GaN substrate wafer to be produced.

In this preferred embodiment, there is desirably no variation in the carrier concentration along the c-axis direction inside the specific doped region 6a. Accordingly, a variation in the donor impurity total concentration along the c-axis direction in the specific doped region 6a is preferably within ±25%, more preferably within ±20%, still more preferably within ±15%, yet still more preferably within ±10%, from a median value.

The GaN film 6 may have an intervening region 6b between the specific doped region 6a and the second c-plane GaN wafer 5. The intervening region 6b is not restricted at all in terms of doping. For example, only a portion of the intervening region 6b may be intentionally doped. This "intervening region" is equivalent to a region that does not correspond to the specific doped region 6a on the GaN film 6. In other words, the donor impurity total concentration of the intervening region is lower than 1 × 10¹⁸ atoms/cm³.

In one example, a dopant of the same kind as the one added to the specific doped region 6a may be added to at least a portion of the intervening region 6b, and the concentration of the dopant may increase continuously or stepwise in the intervening region 6b toward the specific doped region 6a.

The thickness of the intervening region 6b may be set such that the thickness of the GaN film 6 combining the specific doped region 6a and the intervening region 6b does not exceed 500 µm, and it is preferably 50 µm or less, more preferably 40 µm or less, still more preferably 20 µm or less, and may be 10 µm or less.

In one example, by controlling the total concentration of donor impurities excluding Si in the specific doped region 6a to be 10% or less, 5% or less, or 1% or less of the Si concentration, the carrier concentration in the same region can be controlled through adjustment of the Si concentration.

When the specific doped region 6a is doped with Ge and the concentration thereof is 1 × 10¹⁸ atoms/cm³ or higher, the Si concentration in the same region is preferably 4 × 10¹⁷ atoms/cm³ or higher.

In order to prevent marked deterioration of the crystal quality caused by excessive doping, a maximum value of the donor impurity total concentration in the GaN film 6 can be set at 5 × 10¹⁹ atoms/cm³ or lower, 2 × 10¹⁹ atoms/cm³ or lower, or 1 × 10¹⁹ atoms/cm³ or lower.

In the production of the above-described GaN substrate wafer 100 according to one embodiment, taking into consideration the design thickness of the second region 120 of the GaN substrate wafer, a growth thickness t6g of the GaN film 6 is set between 20 µm and 500 µm.

The growth thickness t6g of the GaN film 6 may be the same as the design thickness of the second region 120 in the GaN substrate wafer to be produced; however, the growth thickness t6g is preferably greater than the design thickness. This is because it enables to planarize the surface of the GaN film 6 in the subsequent thinning step. In this case, the growth thickness t6g of the GaN film 6 is greater than the design thickness of the second region 120 by preferably at least 50 µm, more preferably at least 100 µm, but preferably 200 µm or less. In other words, a difference in the thickness of the GaN film 6 before and after the thinning step is preferably 200 µm or smaller.

When the growth thickness t6g of the GaN film 6 is greater than the design thickness of the second region 120 by 50 µm or more, the thickness of the GaN film 6 is reduced by at least 50 µm in the subsequent thinning step. In other words, a difference in the thickness of the GaN film 6 before and after the thinning step is 50 µm or larger.

Since the growth thickness t6g does not exceed 500 µm, the GaN film 6 can be formed in a relatively short time and, therefore, the GaN film 6 can be grown on a large number of second c-plane GaN wafers 5 at once without a concern for clogging of an exhaust system of HVPE apparatus caused by a byproduct NH₄Cl (ammonium chloride). Consequently, the through-put in the third step can be extremely high.

Moreover, the point that the formation of the GaN film 6 requires a short time can also contribute to a reduction in the cost associated with cleaning and maintenance of an HVPE reactor. This is because deterioration of an HVPE reactor is slower when the time required for a single growth step is short, and this leads to a longer service life.

After the third step, as required, the thinning step of thinning the laminated structure obtained in the third step is performed as illustrated in FIG. 7(c).

In FIG. 7(c), not only the thickness of the second c-plane GaN wafer 5 is reduced from the initial thickness t5i to a final thickness t5f, but also the thickness of the GaN film 6 is reduced from the growth thickness t6g to a final thickness t6f; however, in the thinning step, only either one of the second c-plane GaN wafer 5 and the GaN film 6 may be processed.

In the production of the above-described GaN substrate wafer 100 according to one embodiment, the thickness of the second c-plane GaN wafer 5 and that of the GaN film 6 are reduced in the thinning step until they match the design thickness of the first region 110 and that of the second region 120 in the resulting GaN substrate wafer, respectively.

A method to be used for processing the second c-plane GaN wafer 5 and/or the GaN film 6 in the thinning step can be selected as appropriate from grinding, wrapping, CMP, dry etching, wet etching, and the like.

When the off-cut orientation of the GaN substrate wafer 100 to be produced is the same as that of the second c-plane GaN wafer 5, the N-polar surface of the laminated structure to be processed, namely the back surface of the second c-plane GaN wafer 5, can be used as a reference of the plane orientation.

When the off-cut orientation of the GaN substrate wafer 100 to be produced is different from that of the second c-plane GaN wafer 5, i.e. when at least either the off-cut angle or the off-cut direction is different, the crystal orientation of the laminated structure to be processed is verified using an X-ray diffractometer.

By employing the above-described production method, the GaN substrate wafer 100 according to one embodiment can be produced with a higher yield.

The reason for this is because the production method includes neither the step of growing an intentionally doped thick GaN film by HVPE to a thickness in the order of millimeters, nor the step of slicing a thick GaN film grown in such a manner.

In the first step and the second step, thick GaN films may be grown by HVPE to a thickness in the order of millimeters; however, the first thick GaN film 2 and the second thick GaN film 4 that are grown in these steps are not intentionally doped; therefore, an abnormal morphology or a crack is unlikely to be generated during their growth, and the incidence of cracking during slicing is low as well.

Meanwhile, the GaN film 6 grown in the third step is intentionally doped; however, since the growth thickness of the GaN film 6 is merely 500 µm or less, an abnormal morphology or a crack is unlikely to be generated during its growth. In addition, the GaN film 6 is not required to be sliced. In other words, it is not necessary to perform slicing in the above-described thinning step. Particularly, the GaN film 6 formed in the third step is preferably put through the thinning step without being sliced.

Moreover, according to the above-described production method, a variation of the off-cut angle in the main surfaces of the GaN substrate water 100 can be reduced.

The reason for this is because the warpage of the second thick GaN film 4, which is homoepitaxially grown without being intentionally doped on the first c-plan GaN wafer 3 that is not intentionally doped, can be extremely small and, therefore, a variation in the off-cut angle can be extremely small in the second c-plane GaN wafer 5 sliced from the second thick GaN film 4. A change in the warpage caused by lamination of the GaN film 6 on the second c-plane GaN wafer 5 in the third step is small, and this is attributed to that the GaN film 6 has a small growth thickness of 500 µm or less.

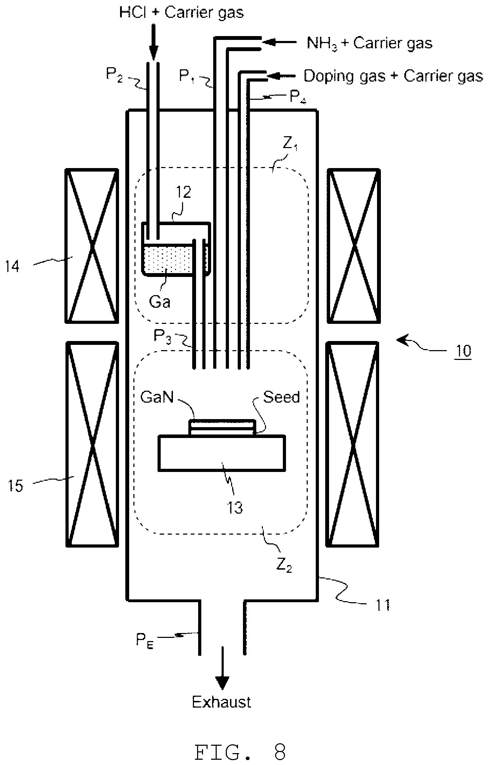

An HVPE apparatus that can be used in the first to the third steps for the production of the GaN substrate wafer 100 by the above-described method will now be described referring to FIG. 8.

An HVPE apparatus 10 illustrated in FIG. 8 includes: a hot wall-type reactor 11; a gallium reservoir 12 and a susceptor 13, which are arranged inside the reactor; and a first heater 14 and a second heater 15, which are arranged on the outside of the reactor. The first heater 14 and the second heater 15 each circularly surround the reactor 11.

The reactor 11 is a quartz tube chamber. Inside the reactor 11, there are a first zone Z1 mainly heated by the first heater 14, and a second zone Z2 mainly heated by the second heater 15. An exhaust pipe PE is connected to a reactor end on the side of the second zone Z2.

The gallium reservoir 12 arranged in the first zone Z1 is a quartz container having a gas inlet and a gas outlet. The susceptor 13 arranged in the second zone Z2 is formed of, for example, graphite. A mechanism for rotating the susceptor 13 may be arranged as desired.

In order to grow GaN using the HVPE apparatus 10, after placing a seed on the susceptor 13, the inside of the reactor 11 is heated by the first heater 14 and the second heater 15. At the same time, NH₃ (ammonia) diluted with a carrier gas is supplied to the second zone Z2 through an ammonia introduction pipe P1, and HCl (hydrogen chloride) diluted with a carrier gas is supplied to the gallium reservoir 12 through a hydrogen chloride introduction pipe P2. This HCl reacts with gallium metal contained in the gallium reservoir 12, and the resulting GaCl (gallium chloride) is transferred to the second zone Z2 through a gallium chloride introduction pipe P3.

In the second zone Z2, NH₃ and GaCl react with each other, and the resulting GaN is crystallized on the seed placed on the susceptor 13.

When doping the growing GaN, a doping gas diluted with a carrier gas is introduced to the second zone Z2 inside the reactor 11 through a dopant introduction pipe P4.

With regard to the ammonia introduction pipe P1, the hydrogen chloride introduction pipe P2, the gallium chloride introduction pipe P3 and the dopant introduction pipe P4, their parts that are arranged inside the reactor 11 are formed of quartz.

As the carrier gas used for diluting each of NH₃, HCl and the doping gas, H₂ (hydrogen gas), N₂ (nitrogen gas), or a mixed gas of H₂ and N₂ is preferably used.

Preferred conditions for growing GaN using the HVPE apparatus 10 are as follows.

The temperature of the gallium reservoir is, for example, 500 to 1,000°C, preferably 700°C or higher, but preferably 900°C or lower.

The temperature of the susceptor is, for example, 900 to 1,100°C, preferably 930°C or higher, more preferably 950°C or higher, but preferably 1,050°C or lower, more preferably 1,020°C or lower.

A V/III ratio which is a ratio between the NH₃ partial pressure and the GaCl partial pressure in the reactor is, for example, 1 to 20, preferably 2 or higher, more preferably 3 or higher, but preferably 10 or lower.

An excessively high or low V/III ratio causes deterioration of the growth surface morphology of GaN. Deterioration of the growth surface morphology can be a cause of a reduction in the crystal quality.

For a certain kind of impurity, the efficiency of incorporation into a GaN crystal is strongly dependent on the crystal orientation of the growth surface. The uniformity of the concentration of such an impurity is reduced inside a GaN crystal grown under a condition where the morphology of the growth surface is not favorable. This is because facets having various orientations exist on the growth surface with a poor morphology.

A typical example of an impurity that has a varying efficiency of incorporation into a GaN crystal depending on the crystal orientation of the growth surface is O (oxygen), and the present inventors found that Ge (germanium) also has the same tendency. As described below, the reason why an excessive reduction of the H₂ molar ratio in the carrier gas is not preferred at the time of doping the GaN film 6 with Ge in the third step relates to this finding.

In addition, an excessively low V/III ratio leads to an increase in the nitrogen vacancy concentration in the growing GaN crystal. The effects of nitrogen vacancies on a GaN crystal, a GaN substrate using a GaN crystal, or a nitride semiconductor device formed on such a GaN substrate are not clear at present; however, since nitrogen vacancies are point defects, it is believed that the concentration thereof should be reduced as much as possible.

The growth rate of GaN can be controlled using the product of the NH₃ partial pressure and the GaCl partial pressure in the reactor as a parameter. The growth rate is, for example, 20 to 200 µm/h. Particularly, when the GaN film 6 is grown in the third step, the growth rate is preferably 120 µm/h or lower, more preferably 100 µm/h or lower, still more preferably 80 µm/h or lower. This is because an excessively high growth rate leads to deterioration of the surface morphology of the growing GaN.

When the GaN film 6 is intentionally doped in the third step, in order to prevent deterioration of the growth surface morphology, it is preferred to gradually increase the supply rate of the doping gas to a prescribed value over a period of several minutes to several ten minutes from the start of the supply.

For the same reason, it is preferred to start the supply of the doping gas once the GaN film 6 has been grown to at least several micrometers.

As the doping gas for Si doping, SiH₄ (silane), SiH₃Cl (monochlorosilane), SiH₂Clₛ (dichlorosilane), SiHCl₃ (trichlorosilane), or SiCl₄ (tetrachlorosilane) can be preferably used.

As the doping gas for Ge doping, GeH₄ (germane), GeH₃Cl (monochlorogermane), GeH₂Clₛ (dichlorogermane), GeHCl₃ (trichlorogermane), or GeCl₄ (tetrachlorogermane) can be preferably used.

The molar ratio of H₂ in the carrier gas can affect the impurity concentrations of the growing GaN. The "molar ratio of H₂ in the carrier gas" is calculated based on the flow rates of the respective gas species supplied as the carrier gas from the outside of the reactor into the reactor.

Table 1 below shows the results of investigating how the impurity concentrations in Si- or Ge-doped GaN, which was grown by HVPE using the same V/III ratio at substantially the same growth rate on a Ga-polar surface of a c-plane GaN wafer cut out from a GaN crystal grown by HVPE on a sapphire substrate, varied depending on the molar ratio of H₂ in a carrier gas.

**[Table 1]**

| Impurity | Concentration in Si-doped GaN [atoms/cm³] | | Concentration in Ge-doped GaN [atoms/cm³] | | DL (Lower detection limit) [atoms/cm³] |
|---|---|---|---|---|---|
| | H₂ molar ratio = 0 | H₂ molar ratio = 0.7 | H₂ molar ratio = 0 | H₂ molar ratio = 0.7 | |
| Si | 8×10¹⁷ | 2×10¹⁸ | 7×10¹⁶ | 4×10¹⁷ | 7×10¹⁴ |
| Ge | < DL | < DL | 1×10¹⁹ | 6×10¹⁷ | 1×10¹⁵ |
| O | 6×10¹⁶ | 8×10¹⁵ | 2×10¹⁷ | 1×10¹⁶ | 5×10¹⁵ |
| H | 4×10¹⁶ | < DL | 7×10¹⁶ | < DL | 3×10¹⁶ |
| C | < DL | < DL | < DL | < DL | 3×10¹⁵ |
| Cl | < DL | < DL | < DL | < DL | 2×10¹⁴ |

As seen from Table 1, the O concentration in Si-doped GaN is 10% or less of the Si concentration when the carrier gas consists of only N₂. This is equivalent to that the total concentration of donors excluding Si is 10% or less of the Si concentration, since O is substantially the only donor other than Si,. The O concentration in Si-doped GaN is further reduced as the molar ratio of H₂ in the carrier gas is increased, and the O concentration is less than 1% of the Si concentration when the molar ratio of H₂ is 0.7.

On the other hand, in Ge-doped GaN, when the molar ratio of H₂ in the carrier gas is 0 (zero), the Ge concentration is at least 10 times higher and the ratio of the Ge concentration with respect to the Si concentration is also higher as compared to when the molar ratio of H₂ is 0.7. Accordingly, at a glance, a lower molar ratio of H₂ in the carrier gas appears to be more preferred.

However, comparing a case where the molar ratio of H₂ in the carrier gas is 0 and a case where it is 0.7, as seen from the fact that the O concentration is also higher by one digit in the former case, the present inventors have confirmed that the growth surface morphology of GaN is poor under the condition of the former case, and a high Ge concentration is also attributed thereto. A GaN crystal having a low uniformity in the Ge concentration is grown under a condition where the molar ratio of H₂ in the carrier gas is excessively low.

Therefore, for the growth of Ge-doped GaN, the molar ratio of H₂ in the carrier gas is preferably about 0.3 to 0.7 and, in Ge-doped GaN grown in this manner, the Si concentration is 4 × 10¹⁷ atoms/cm³ or higher when the Ge concentration is 1 × 10¹⁸ atoms/cm³ or higher.

Regardless of whether GaN grown by HVPE is doped with Si or Ge, the O concentration of GaN tends to be reduced by increasing the molar ratio of H₂ in the carrier gas, and can be 2 × 10¹⁶ atoms/cm³ or lower, or 1 × 10¹⁶ atoms/cm³ or lower. This is because the surface morphology during the growth is improved.

GaN grown by the HVPE apparatus 10, even when not intentionally doped, can contain O and Si at concentrations detectable by SIMS. An Si source is quartz (SiO₂) used in the reactor and the pipes inside the reactor, and an O source is either or both of such quartz and water remaining inside or entering into the reactor.

Including those components omitted in FIG. 8, the components arranged inside the reactor 11 can be formed of, for example, SiC (silicon carbide), SiNₓ (silicon nitride), BN (boron nitride), alumina, W (tungsten) and Mo (molybdenum), in addition to quartz and carbon. This enables to control the concentration of each impurity excluding Si, O and H in GaN grown by the HVPE apparatus 10 to be 5 × 10¹⁵ atoms/cm³ or lower, unless GaN is intentionally doped.

### EXAMPLES

The present invention will now be described more concretely by way of Examples thereof. The present invention, however, is not restricted to the below-described Examples, and various applications can be made without departing from the technical idea of the present invention.

### [Example]

### <Production of Second c-Plane GaN Wafer (Second Step)>

First, a GaN seed was set on a susceptor of an HVPE apparatus. A GaN template substrate on sapphire, which was prepared by MOCVD (metalorganic chemical vapor deposition), was used as the GaN seed, and the c-plane side thereof was used as a growth surface.

Next, while supplying N₂, H₂ and NH₃ into a reactor such that their partial pressures were 0.67 atm, 0.31 atm and 0.02 atm, respectively, the inside of the reactor was heated using heaters arranged on the outside of the reactor.

Once the susceptor temperature reached 1,000°C, the susceptor temperature was maintained constant so as to allow GaN to grow. The temperature of a gallium reservoir was set at 900°C. A carrier gas supplied into the reactor during the growth contained 69% by mole of H₂, and the remainder was N₂.

GaCl and NH₃ were supplied into the reactor such that their partial pressures were 7.9 × 10⁻³ atm and 0.024 atm, respectively, whereby a second thick GaN film containing no donor impurity was grown to a thickness of about 2.5 mm. The growth rate of the second thick GaN film, which was calculated from the thickness and the growth time, was about 40 µm/h.

Subsequently, the thus obtained thick GaN film was sliced parallel to the c-plane to obtain a wafer, and the Ga-polar surface of this wafer was subjected to planarization by grinding and subsequent CMP finishing. Slice damages on the N-polar surface side of the wafer were removed by etching. Further, the wafer was cut to produce a 350 µm-thick second c-plane GaN wafer containing no donor impurity.

It is noted here that two or more second c-plane GaN wafers can be obtained by extending the growth time and thereby increasing the thickness of the second thick GaN film.

### <Production of GaN Substrate Wafer (Third Step)>

As a seed, the above-obtained second c-plane GaN wafer was set on a susceptor of an HVPE apparatus such that the c-plane side would be used as a growth surface.

Next, while supplying N₂, H₂ and NH₃ into a reactor such that their partial pressures were 0.25 atm, 0.73 atm and 0.02 atm, respectively, the inside of the reactor was heated using a heater arranged on the outside of the reactor.

Once the susceptor temperature reached 1,000°C, the susceptor temperature was maintained constant so as to allow GaN to grow. The temperature of a gallium reservoir was set at 900°C. A carrier gas supplied into the reactor during the growth contained 73% by mole of H₂, and the remainder was N₂.

During a period of 1 minute immediately after the start of the growth, for surface roughening, HCl and NH₃ were supplied into the reactor such that their partial pressures were 1.7 × 10⁻² atm and 0.024 atm, respectively, and no doping gas was intentionally supplied.

During a period of 60 minutes after the surface roughening, GaCl and NH₃ were supplied into the reactor such that their partial pressures were 7.9 × 10⁻³ atm and 0.024 atm, respectively, and no doping gas was intentionally supplied.

Supply of SiH₂Cl₂ into the reactor was initiated 61 minutes after the start of the growth. The supply rate of SiH₂Cl₂ was gradually increased over a period of 5 minutes.

Once the supply rate of SiH₂Cl₂ reached a prescribed value, GaCl, NH₃ and SiH₂Cl₂ were supplied into the reactor such that their partial pressures were 7.9 × 10⁻³ atm, 0.024 atm and 1.9 × 10⁻⁸ atm, respectively, whereby a GaN film doped with Si as a donor impurity was grown to a thickness of about 0.4 mm. The surface of this GaN film was finished by polishing without slicing to obtain a Si-doped GaN substrate wafer of about 60 mm in diameter.

The growth rate of the Si-doped GaN film, which was calculated from the thickness and the growth time, was about 40 µm/h.

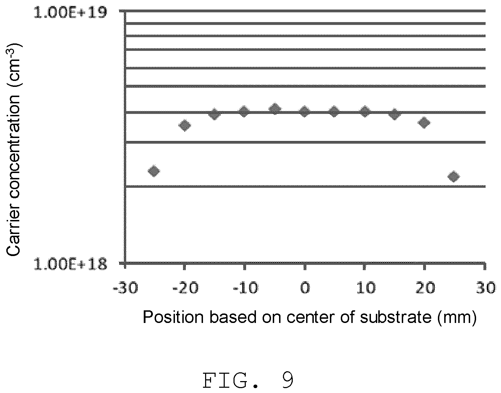

The GaN substrate wafer obtained by the above-described production method was a bilayer substrate having a first region on the N-polar side and a second region on the Ga-polar side along with a regrowth interface, and the carrier concentration of the Ga-polar side, namely the GaN film, was 4.0 × 10¹⁸ cm⁻³. As shown in FIG. 9, the carrier concentration was 1.0 × 10¹⁸ cm⁻³ or higher over the entire surface on the Ga-polar side and stable at roughly 4.0 × 10¹⁸ cm⁻³, except for the end portions. Further, crack generation and surface roughness were not observed.

### [Reference Example]

A GaN film of about 2.5 mm in thickness was obtained by extending the growth time of a Si-doped GaN film to about 6 times of that in the above-described Example. The thus obtained GaN substrate wafer (bilayer substrate) was observed with the formation of abnormally grown parts. The term "abnormally grown parts" used herein refers to deep depressions caused by SiNx that were observed in some parts of the substrate surface.

The present invention has been described based on concrete embodiments; however, these embodiments were presented as examples and should not limit the scope of the present invention. The embodiments described herein can each be variously modified without departing from the spirit of the present invention and, where feasible, may be combined with any feature described by another embodiment.

### DESCRIPTION OF SYMBOLS

- 1:: seed wafer
- 2:: first thick GaN film
- 3:: first c-plane GaN wafer
- 4:: second thick GaN film
- 5:: second c-plane GaN wafer
- 6:: GaN film
- 6a:: specific doped region
- 6b:: intervening region
- 10:: HVPE apparatus
- 11:: reactor
- 12:: gallium reservoir
- 13:: susceptor
- 14:: first heater
- 15:: second heater
- 100:: GaN substrate wafer
- 101:: N-polar surface
- 102:: Ga-polar surface
- 103:: regrowth interface
- 110:: first region
- 120:: second region
- 120a:: main doped region
- 200:: epitaxial film
- 210:: n-type nitride semiconductor layer
- 220:: p-type nitride semiconductor layer
- L:: specific length

## Claims

1. A (0001)-oriented GaN substrate wafer, comprising a first region arranged on an N-polar side and a second region arranged on a Ga-polar side via a regrowth interface therebetween,
wherein the second region has a minimum thickness of 20 µm to 300 µm, and comprises a region having a higher donor impurity total concentration than the first region.

2. The GaN substrate wafer according to claim 1, wherein at least a portion of the region having a higher donor impurity total concentration than the first region has a carrier concentration of 1 × 10¹⁸ cm⁻³ or higher.

3. The GaN substrate wafer according to claim 1 or 2, satisfying any condition selected from the following (1) to (3) :
(1) having a diameter of 50 mm to 55 mm and a thickness of 250 µm to 450 µm;
(2) having a diameter of 100 mm to 105 mm and a thickness of 350 µm to 750 µm; and
(3) having a diameter of 150 mm to 155 mm and a thickness of 450 µm to 800 µm.

4. The GaN substrate wafer according to any one of claims 1 to 3, wherein the second region comprises a main doped region having a donor impurity total concentration of 1 × 10¹⁸ atoms/cm³ or higher.

5. The GaN substrate wafer according to claim 4, wherein, in the second region, a region within a specific length from a main surface of a GaN-polar side is the main doped region, and the specific length is 1 µm or longer.

6. The GaN substrate wafer according to claim 5, wherein the minimum thickness of the second region is 1.2 times or less of the specific length.

7. The GaN substrate wafer according to any one of claims 4 to 6, wherein, in the main doped region, a variation in the donor impurity total concentration along a c-axis direction is in a range of ±25% from a median value.

8. The GaN substrate wafer according to any one of claims 1 to 7, wherein an impurity contained in the second region at the highest concentration is Si or Ge.

9. The GaN substrate wafer according to any one of claims 4 to 7, wherein an impurity contained in the main doped region at the highest concentration is Si or Ge.

10. The GaN substrate wafer according to any one of claims 4 to 9, wherein a total concentration of donor impurities excluding Si in the main doped region is 10% or less of the Si concentration.

11. The GaN substrate wafer according to any one of claims 4 to 10, wherein the main doped region has a Ge concentration of 1 × 10¹⁸ atoms/cm³ or higher and an Si concentration of 4 × 10¹⁷ atoms/cm³ or higher.

12. The GaN substrate wafer according to any one of claims 1 to 11, wherein impurity concentrations of at least one of the first region and the second region satisfy one or more conditions selected from the following (a) to (c):
(a) the Si concentration is 5 × 10¹⁶ atoms/cm³ or higher;
(b) the O concentration is 3 × 10¹⁶ atoms/cm³ or lower; and
(c) the H concentration is 1 × 10¹⁷ atoms/cm³ or lower.

13. The GaN substrate wafer according to any one of claims 1 to 12, wherein the first region has an Si concentration of lower than 1 × 10¹⁸ atoms/cm³.

14. The GaN substrate wafer according to any one of claims 1 to 13, wherein the regrowth interface is a rough surface.

15. The GaN substrate wafer according to any one of claims 1 to 14, wherein a dislocation density on the main surface of the Ga-polar side is 0.5 times to less than 2 times of that of the first region in the vicinity of the regrowth interface.

16. The GaN substrate wafer according to any one of claims 1 to 15, wherein the main surface of the Ga-polar side is a flat surface.

17. An epitaxial wafer, comprising:
the GaN substrate wafer according to any one of claims 1 to 16; and
a nitride semiconductor layer epitaxially grown on a Ga-polar surface of the GaN substrate wafer.

18. A method of producing an epitaxial wafer, the method comprising the steps of:
preparing the GaN substrate wafer according to any one of claims 1 to 16; and
growing a nitride semiconductor layer on a Ga-polar surface of the GaN substrate wafer to obtain an epitaxial wafer.

19. A method of producing a semiconductor device, the method comprising the steps of:
preparing the GaN substrate wafer according to any one of claims 1 to 16;
growing a nitride semiconductor layer on a Ga-polar surface of the GaN substrate wafer to obtain an epitaxial wafer; and
removing at least a portion of the first region of the GaN substrate wafer.

20. A method of producing a GaN substrate wafer, the method comprising:
a second step of obtaining a second c-plane GaN wafer by growing a (0001)-oriented second thick GaN film on a substrate by HVPE and subsequently slicing the second thick GaN film; and
a third step of growing a (0001)-oriented GaN film of 500 µm or less in thickness on the second c-plane GaN wafer by HVPE, which GaN film comprises a region having a higher donor impurity total concentration than the second c-plane GaN wafer.

21. A method of producing a GaN substrate wafer that comprises a first region arranged on an N-polar side and a second region arranged on a Ga-polar side via a regrowth interface therebetween, the method comprising:
(i) a first step of growing a (0001)-oriented first thick GaN film, which is composed of GaN not intentionally doped, on a seed wafer by HVPE, and subsequently obtaining at least one first c-plane GaN wafer from the first thick GaN film;
(ii) a second step of obtaining a second c-plane GaN wafer by growing a (0001)-oriented second thick GaN film, which is composed of GaN not intentionally doped, on the first c-plane GaN wafer by HVPE and subsequently slicing the second thick GaN film; and
(iii) a third step of growing a (0001)-oriented GaN film of 500 µm or less in thickness on the second c-plane GaN wafer by HVPE, which GaN film comprises a region having a higher donor impurity total concentration than the second c-plane GaN wafer.

22. The method of producing a GaN substrate wafer according to claim 20 or 21, wherein at least a portion of the region having a higher donor impurity total concentration than the second c-plane GaN wafer has a carrier concentration of 1 × 10¹⁸ cm⁻³ or higher.

23. The method of producing a GaN substrate wafer according to any one of claims 20 to 22, wherein the GaN substrate wafer satisfies any condition selected from the following (1) to (3):
(1) having a diameter of 50 mm to 55 mm and a thickness of 250 µm to 450 µm;
(2) having a diameter of 100 mm to 105 mm and a thickness of 350 µm to 750 µm; and
(3) having a diameter of 150 mm to 155 mm and a thickness of 450 µm to 800 µm.

24. The method of producing a GaN substrate wafer according to any one of claims 20 to 23, wherein the GaN film comprises a specific doped region which has a length of 1 µm or longer in a c-axis direction from an upper surface of the GaN film, and in which the donor impurity total concentration is 1 × 10¹⁸ atoms/cm³ or higher.

25. The method of producing a GaN substrate wafer according to claim 24, wherein the length of the specific doped region in the c-axis direction is 20 µm or longer.

26. The method of producing a GaN substrate wafer according to claim 24 or 25, wherein, in the specific doped region, a variation in the donor impurity total concentration along the c-axis direction is within a median value ± 25%.

27. The method of producing a GaN substrate wafer according to any one of claims 24 to 26, wherein the GaN film comprises an intervening region of 50 µm or less in thickness between the specific doped region and the second c-plane GaN wafer.

28. The method of producing a GaN substrate wafer according to any one of claims 24 to 27, wherein an impurity contained in the specific doped region at the highest concentration is Si or Ge.

29. The method of producing a GaN substrate wafer according to any one of claims 24 to 28, wherein a total concentration of donors excluding Si in the specific doped region is 10% or less of the Si concentration.

30. The method of producing a GaN substrate wafer according to any one of claims 24 to 29, wherein the specific doped region has a Ge concentration of 1 × 10¹⁸ atoms/cm³ or higher and an Si concentration of 4 × 10¹⁷ atoms/cm³ or higher.

31. The method of producing a GaN substrate wafer according to any one of claims 20 to 30, comprising the thinning step of thinning the GaN film after the third step.

32. The method of producing a GaN substrate wafer according to claim 31, wherein the GaN film has a thickness difference of 200 µm or less before and after the thinning step.

33. The method of producing a GaN substrate wafer according to any one of claims 20 to 32, wherein the GaN substrate wafer and the second c-plane GaN wafer have different off-cut orientations.

34. The method of producing a GaN substrate wafer according to any one of claims 20 to 33, further comprising, between the second step and the third step:
the planarization step of planarizing a Ga-polar surface of the second c-plane GaN wafer obtained in the second step; and
the roughening step of roughening the Ga-polar surface by etching.

35. The method of producing a GaN substrate wafer according to any one of claims 31 to 34, wherein the thinning of the GaN film in the thinning step is performed without slicing.
